# EUROPÄISCHE PATENTSCHRIFT

(11) **EP 1 665 482 B1**
(45) Veröffentlichungstag und Bekanntmachung des Hinweises auf die Patenterteilung: **28.11.2007**
(21) Anmeldenummer: 04763707.9
(22) Anmeldetag: 02.08.2004
(51) Int. Cl.: H01S 5/042, H01S 5/068, H01S 5/0683

(54) **SCHALTUNGSANORDNUNG ZUM EIN- UND AUSSCHALTEN EINER LASERDIODE**
CIRCUIT ARRANGEMENT FOR SWITCHING A LASER DIODE ON AND OFF
ENSEMBLE CIRCUIT POUR LA MISE SOUS ET HORS TENSION D'UNE DIODE LASER

(30) Priorität: 24.09.2003 DE 10344486
(43) Veröffentlichungstag der Anmeldung: 07.06.2006
(73) Patentinhaber: IC-HAUS GmbH, D-55294 Bodenheim (DE)
(72) Erfinder: HERZ, Manfred, 55130 Mainz (DE); PINEDA, Carcia, Alvaro, 55296 Nackenheim (DE); BURKARD, Ralf, 65321 Kemel (DE)
(74) Vertreter: Kampfenkel, Klaus
(86) Internationale Anmeldenummer: PCT/EP2004/008637
(87) Internationale Veröffentlichungsnummer: WO 2005/041370

(56) Entgegenhaltungen:
- GB-A- 2 036 494
- US-A- 5 107 362
- US-A- 5 123 023
- US-A- 5 182 756
- US-A1- 2003 035 451
- US-A1- 2003 138 010
- US-B1- 6 259 714
- PATENT ABSTRACTS OF JAPAN Bd. 0123, Nr. 28 (E-654), 6. September 1988 (1988-09-06) & JP 63 090876 A (MATSUSHITA ELECTRIC IND CO LTD), 21. April 1988 (1988-04-21)

## Beschreibung

Die Erfindung betrifft eine Schaltungsanordnung zum Ein- und Ausschalten einer Laserdiode.

Schaltungsanordnungen zum Regeln der Lichtleistung einer Laserdiode sind bekannt, bei denen eine als Monitordiode fungierende Fotodiode optisch mit der Laserdiode gekoppelt ist, um die Lichtleistung der Laserdiode kontrollieren zu können. Eine solche Schaltungsanordnung ist beispielsweise in der DE 200 07 884 offenbart.

US 2003/035451 A1 offenbart eine Schaltungsanordnung zum Ein- und Ausschalten einer Laserdiode, mit wenigstens einer Laserdiode, einer Regeleinrichtung zur Regelung der Lichtleistung der Laserdiode im eingeschalteten Zustand der Laserdiode und einer zweiten Regeleinrichtung zur Regelung eines die Laserdiode ansteuernden Ausgangsruhestroms im ausgeschalteten Zustand der Laserdiode.

US 2003/138010 A1 beschreibt eine integrierte Schaltung zum Regeln der Lichtleistung einer Laserdiode. Sofern eine vorbestimmte Betriebstemperatur der Laserdiode überschritten wird, wird der Strom auf null Ampere oder einen vorbestimmten Wert größer als null Ampere begrenzt.

Herkömmliche Regelkreise zur Regelung der Lichtleistung einer Laserdiode zeichnen sich dadurch aus, dass sie die Lichtleistung der Laserdiode mit Hilfe der Fotodiode im eingeschalteten Zustand regeln, wohingegen der Regelkreis im ausgeschalteten Zustand der Laserdiode offen oder abgeschaltet ist. Im ausgeschalteten Zustand der Laserdiode besteht dann keine Lichtkopplung mehr zwischen der Laserdiode und der Fotodiode. Demzufolge muss sich der Regelkreis beim erneuten Einschalten der Laserdiode erst wieder länger einschwingen.

Der vorliegenden Erfindung liegt daher die Aufgabe zugrunde, eine Schaltungsanordnung zum Ein- und Ausschalten einer Laserdiode bereitzustellen, bei der ein Einschwingen des Regelkreises beim erneuten Einschalten der Laserdiode im Wesentlichen nicht auftritt, wodurch schnellere Ein-/Ausschaltzyklen erzielt werden können.

Ein Kerngedanke der Erfindung ist darin zu sehen, dass im eingeschalteten Zustand die Lichtleistung der Laserdiode geregelt wird, während im ausgeschalteten Zustand, bei dem die Laserdiode kein Laserlicht erzeugt, der zu regelnde Ausgangsruhestrom derart geregelt wird, dass er unterhalb des charakteristischen Schwellstroms der Laserdiode liegt.

Die Erfindung basiert auf der Erkenntnis, dass eine Laserdiode einen Laserdioden-Schwellstromwert besitzt, bei dessen Überschreitung die Laserdiode ihren Betriebszustand von einer spontanen Emission, wie sie eine aktive LED (Light Emitting Diode) zeitigt, zu einer stimulierten Emission (Laser Effekt) wechselt. Dies bedeutet, dass die Laserdiode mit einem Ausgangsruhestrom, der unterhalb des Laserdioden-Schwellstroms liegt, angesteuert werden kann, ohne dass sie Laserlicht erzeugt. Die Erfindung bedient sich dieses Effektes, um die Regelung der Laserdiode auch im ausgeschalteten Zustand, in dem also kein Laserlicht erzeugt wird, aktiv zu halten.

Das oben genannte technische Problem löst die Erfindung gemäß Anspruch 1 durch eine Schaltungsanordnung zum Ein- und Ausschalten einer Laserdiode. Die Schaltungsanordnung weist wenigstens eine Laserdiode und eine, lediglich ein Stellglied aufweisende, Regeleinrichtung auf, die im eingeschalteten Zustand der Laserdiode deren Lichtleistung regelt und die im ausgeschalteten Zustand einen Ausgangsruhestrom unterhalb des Schwellstroms der Laserdiode regelt.

An dieser Stelle sei noch einmal betont, dass als ausgeschalteter Zustand der Zustand der Laserdiode verstanden wird, in dem die Laserdiode kein Laserlicht erzeugt. Unter Ausgangsruhestrom ist ein Strom unterhalb des Laserdioden-Schwellstroms gemeint, bei dem die Laserdiode nicht aktiv ist oder lediglich im spontanen Emissionsbetrieb arbeitet.

Vorteilhafte Weiterbildungen sind Gegenstand der Unteransprüche.

Die Regeleinrichtung weist eine mit der Laserdiode optisch gekoppelte Fotodiode und eine in Abhängigkeit vom Ausgangsruhestrom gesteuerte Stromquelle auf.

Die Fotodiode ist nur im eingeschalteten Zustand mit einer ersten Stromquelle verbunden, wohingegen die gesteuerte Stromquelle nur im ausgeschalteten Zustand mit einer zweiten Stromquelle verbunden ist. Die erste Stromquelle liefert einen größeren Sollstrom als die zweite Stromquelle.

Es sei angemerkt, dass im ausgeschalteten Zustand der Laserdiode der zu regelnde Ausgangsruhestrom dem Produkt aus dem Sollstrom der zweiten Stromquelle und dem Kopplungfaktor zwischen einem Strommesser und der gesteuerten Stromquelle entspricht. Der Strommesser mißt den im ausgeschalteten Zustand zu regelnden Ausgangsruhestrom der Regeleinrichtung.

Insbesondere stellt die erste Stromquelle einen Monitordioden-Sollstrom bereit, auf den sich der Monitordiodenstrom der Fotodiode, der von der in die Fotodiode eingekoppelten Lichtleistung der Laserdiode abhängt, im eingeregelten Zustand einstellt. Die zweite Stromquelle liefert einen vorbestimmten Sollstrom, der so gewählt wird, dass der Ausgangsruhestrom unterhalb des Laserdioden-Schwellstroms liegt.

Die mit der Laserdiode optisch gekoppelte Fotodiode dient in an sich bekannter Weise dazu, während des eingeschalteten Zustands die Lichtleistung der aktiven Laserdiode zu erfassen, um eine Regelung der Lichtleistung der Laserdiode zu ermöglichen. Die gesteuerte Stromquelle wiederum sorgt zusammen mit der zweiten Stromquelle dafür, dass im ausgeschalteten Zustand der Ausgangsruhestrom durch die erste Schalteinrichtung derart geregelt wird, dass die Laserdiode nur im LED-Betrieb arbeitet, d.h. kein Laserlicht erzeugt.

Die erste, zweite und die gesteuerte Stromquelle sowie die Fotodiode können an einen Eingang eines Komparators angeschlossen werden. An dem anderen Eingang des Komparators ist eine Referenzspannung angelegt.

Eine zweckmäßige Ausführungsform sieht vor, dass dem Komparator ein Verstärker nachgeschaltet ist. Komparator und Verstärker bilden das Stellglied der Regeleinrichtung. Bei dieser Ausführungsform kann der Strommesser zwischen der Laserdiode und dem Verstärker angeordnet sein.

Um die Regelung im ein- und ausgeschalteten Zustand der Laserdiode aktiv halten zu können, ist eine erste gesteuerte Schalteinrichtung, die die erste Stromquelle oder die zweite Stromquelle mit dem einen Eingang des Komparators verbinden kann, und eine zweite gesteuerte Schalteinrichtung, die die gesteuerte Stromquelle mit dem einen Eingang des Komparators verbinden kann, vorgesehen.

Um im ausgeschalteten Zustand der Laserdiode den zu regelnden Ausgangsruhestrom vollständig an der Laserdiode vorbeiführen zu können, ist parallel zur Laserdiode ein Widerstand geschaltet. Auf diese Weise wird sichergestellt, dass die Laserdiode im ausgeschalteten Zustand kein oder nur ein sehr geringes Restlicht erzeugt.

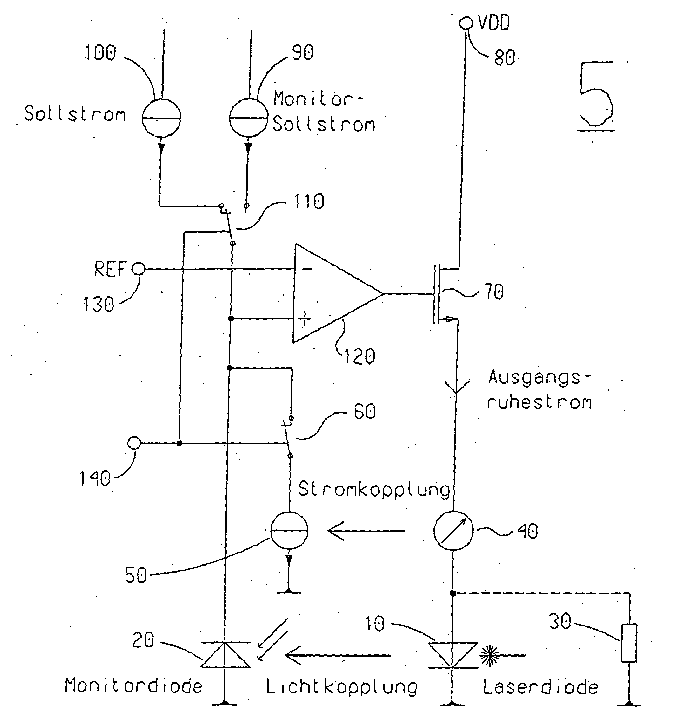

Die Erfindung wird nachfolgend anhand eines Ausführungsbeispiels in Verbindung mit der beiliegenden Figur näher erläutert.

Die in der Figur gezeigte Schaltungsanordnung 5 zum Ein- und Ausschalten einer Laserdiode 10 weist ausgangsseitig eine Reihenschaltung aus einem Verstärker 70, einem Strommesser 40 und der Laserdiode 10 auf. Bei dem Verstärker 70 kann es sich um einen Feldeffekttransistor handeln. An einem der Drain-Elektrode zugeordneten Anschluss 80 des Verstärkers 70 ist eine Versorgungsspannung V_{dd} angelegt. Parallel zur Laserdiode 10 ist ein Shunt-Widerstand 30 geschaltet, der, wie nachfolgend noch näher erläutert wird, im ausgeschalteten Zustand der Laserdiode 10 den durch den Verstärker 70 fließenden, zu regelnden Ausgangsruhestrom im Wesentlichen abführt. Dadurch wird erreicht, dass die Laserdode 10 kein oder nur ein sehr geringes Licht im LED-Betrieb erzeugt. An der Steuerelektrode des Verstärkers 70 ist der Ausgang eines Komparators 120 angeschlossen. An einen dem negativen Eingang des Komparators 120 zugeordneten Anschluss 130 ist eine Referenzspannungsquelle REF angeschlossen. Mit der Laserdiode 10 ist eine Monitordiode 20 optisch gekoppelt, die mit dem positiven Eingang des Komparators 120 verbunden ist. Im ausgeschalteten Zustand ist parallel zur Monitordiode 20 eine gesteuerte Stromquelle 50 geschaltet, die elektrisch mit dem Strommesser 40 gekoppelt ist. Die gesteuerte Stromquelle 50 ist über einen Schalter 60 an den positiven Eingang des Komparators 120 anschaltbar. Der Schalter 60 wird über ein Ein-/Aus-Steuersignal gesteuert, welches an einem Anschluss 140 angelegt werden kann. Ferner können abwechselnd eine Stromquelle 100 zur Erzeugung eines Sollstroms sowie eine weitere Stromquelle 90 zum Bereitstellen eines Monitordioden-Sollstroms über einen Schalter 110 mit dem positiven Eingang des Komparators 120 verbunden werden. Dem Schalter 110 wird über den Anschluss 140 das Ein-/Aus-Steuersignal zugeführt.

Die in der Figur dargestellten Schalterstellungen entsprechen dem ausgeschalteten Zustand der Laserdiode 10, in dem die Laserdiode 10 kein Laserlicht erzeugt. Im eingeschalteten Zustand der Laserdiode 10 verbindet der Schalter 110 die Stromquelle 90 mit dem positiven Eingang des Komparators 120 und trennt gleichzeitig die gesteuerte Stromquelle 50 vom positiven Eingang des Komparators 120.

Nachfolgend wird die Funktionsweise der in der Figur dargestellten Schaltungsanordnung 5 näher erläutert.

Zunächst betrachten wir die Schaltungsanordnung 5 im eingeschalteten Zustand der Laserdiode 10. In diesem Fall ist die Stromquelle 90 über den Schalter 110 an den positiven Eingang des Komparators 120 angelegt, während der Schalter 60 geöffnet ist. Zur Regelung des durch den Schalttransistors 70 fließenden Lasersteuerstroms wird die Laserlichtleistung in der Monitordiode 20 erfasst, die in Abhängigkeit von der eingekoppelten Lichtleistung einen Monitordiodenstrom erzeugt. Ist der erzeugte Monitordiodenstrom kleiner als der von der Stromquelle 90 gelieferte Monitordioden-Sollstrom, steigt das Potential am positiven Eingang des Komparators 120 an und der Verstärker 70 wird weiter geöffnet. Folglich wird auch der Lasersteuerstrom erhöht. Demzufolge wird die Lichtleistung der Laserdiode 10 erhöht, die wiederum für einen größeren Monitordiodenstrom der Monitordiode 20 sorgt. Im eingeregelten Zustand ist der von der Monitordiode 20 erzeugte Monitordiodenstrom gleich dem Monitordioden-Sollstrom der Stromquelle 90. Wie anhand der Figur erkennbar ist, setzt sich der Regelkreis im eingeschalteten Zustand der Laserdiode 10 aus dem Verstärker 70, der Laserdiode 10, der Monitordiode 20, der Stromquelle 90 und dem Komparator 120 zusammen. Der Komparator 120 und der Verstärker 70 bilden zusammen das Stellglied des Regelkreises.

Soll nunmehr die Laserdiode 10 ausgeschaltet werden, werden die Schalter 110 und 60 durch das am Eingang 140 anliegende Ei-/Aus-Steuersignal in die in der Figur gezeigten Schalterstellungen bewegt. Bemerkenswert ist nunmehr, dass im ausgeschalteten Zustand der Regelkreis nicht aufgetrennt oder abgeschaltet wird, sondern nunmehr über den Verstärker 70, den Strommesser 40, die gesteuerte Stromquelle 50, den Schalter 60, die Stromquelle 100 und den Komparator 120 aufrechterhalten wird. Ziel der Regelung ist es, den durch den Verstärker 70 fließenden Ausgangsruhestrom derart zu begrenzen, dass die Laserdiode 10 kein Laserlicht mehr erzeugt, sondern im LED-Modus betrieben wird. Hierzu ist erforderlich, dass der durch den Verstärker 70 fließende Ausgangsruhestrom kleiner ist als der Laserdioden-Schwellstrom. Demzufolge liefert die Stromquelle 100 einen Sollstrom, der zusammen mit dem Kopplungsfaktor zwischen dem Strommesser 40 und der gesteuerten Stromquelle 50 dafür sorgt, dass der zu regelnde Ausgangsruhestrom kleiner als der Laserdioden-Schwellstrom bleibt. Es sei angemerkt, dass im ausgeschalteten Zustand der durch die Monitordiode 20 hervorgerufene Strom gegenüber dem für die Regelung maßgeblichen Strom der gesteuerten Stromquelle 50 vernachlässigbar klein bleibt.

Im ausgeschalteten Zustand wird der durch den Verstärker 70 fließende Ausgangsruhestrom in dem Strommesser 40 gemessen und als Steuergröße der gesteuerten Stromquelle 50 zugeführt. Die Regelung funktioniert derart, dass im eingeregelten Zustand der Sollstrom der Stromquelle 100 gleich dem Strom der gesteuerten Stromquelle 50 ist.

Wird die Laserdiode 10 erneut eingeschaltet, wird der Schalter 60 wieder geöffnet und die Stromquelle 90 über den Schalter 110 mit der Monitordiode 20 verbunden. Der Ausgangsruhestrom steigt folglich über den Wert des Laserdioden-Schwellstroms an, so dass die Laserdiode 10 wieder Laserlicht erzeugt. Ab diesem Moment wird nicht mehr der Ausgangsstrom, sondern die Laserlichtleistung der Laserdiode 10 geregelt.

Da die Regelung, wie erläutert, auch im ausgeschalteten Zustand der Laserdiode 10 aktiv ist, muss der Regelkreis beim erneuten Einschalten nicht einschwingen, sondern er wechselt nur den Arbeitspunkt ober- und unterhalb des Laseerdioden-SAchwellstroms. Dadurch ist ein wiederholtes, reproduzierbares schnelles Ein- und Ausschalten der Laserdiode 10 mit einer Regelung der Lichtleistung im eingeschalteten Zustand der Laserdiode 10 möglich.

### Bezugszeichen

- 10: Laserdiode
- 20: Fotodiode als Monitordiode
- 30: Shunt-Widerstand
- 40: Strommesser
- 50: gesteuerte Stromquelle
- 60: Schalter
- 70: Verstärker
- 80: Versorgungsspannung
- 90: Stromquelle zum Bereitstellen eines Monitor-Sollsstroms
- 100: Stromquelle zum Bereitstellen eines Sollstroms
- 110: Schalter
- 120: Komparator
- 130: Anschluss für Referenzspannungsquelle
- 140: Anschluss für Ein-/Ausschaltsignal

## Patentansprüche

1. Schaltungsanordnung (5) zum Ein- und Ausschalten einer Laserdiode (10), mit
wenigstens einer Laserdiode (10) und
einer, lediglich ein Stellglied (70, 120) aufweisenden, Regeleinrichtung, die im eingeschalteten Zustand der Laserdiode (10)deren Lichtleistung regelt und die im ausgeschalteten Zustand der Laserdiode (10) einen die Laserdiode (10) ansteuernden Ausgangsruhestrom derart regelt, dass dieser unterhalb des charakteristischen Schwellstroms der Laserdiode (10) liegt.

2. Schaltungsanordnung nach Anspruch 1,
**dadurch gekennzeichnet, dass**
die Regeleinrichtung eine mit der Laserdiode (10) optisch gekoppelte Fotodiode (20) und eine in Abhängigkeit vom Ausgangsruhestrom gesteuerte Stromquelle (50) aufweist,
wobei die Fotodiode (20) nur im eingeschalteten Zustand mit einer ersten Stromquelle (90) und die gesteuerte Stromquelle (50) nur im ausgeschalteten Zustand mit einer zweiten Stromquelle (100) verbunden ist, wobei die erste Stromquelle (90) einen größeren Ausgangsruhestrom als die zweite Stromquelle (100) verursacht.

3. Schaltungsanordnung nach Anspruch 2,
**dadurch gekennzeichnet, dass**
die Regeleinrichtung einen Komparator (120) aufweist, und dass
die erste, zweite und die gesteuerte Stromquelle (90, 100, 50) sowie die Fotodiode (20) an einen Eingang (+) des Komparators (120), anschaltbar sind, und dass
an den anderen Eingang (-) des Komparators (120) eine Referenzgröße anlegbar ist.

4. Schaltungsanordnung nach Anspruch 2 oder 3,
**gekennzeichnet durch**
einen mit der gesteuerten Stromquelle (50) elektrisch gekoppelten Strommesser (40) zum Messen des Ausgangsruhestroms.

5. Schaltungsanordnung nach Anspruch 3 oder 4,
**dadurch gekennzeichnet, dass**
dem Komparator (120) ein Verstärker (70) nachgeschaltet ist, und dass
der Strommesser (40) zwischen der Laserdiode (10) und dem Verstärker (70) angeordnet ist.

6. Schaltungsanordnung nach einem der Ansprüche **3** bis 5, **gekennzeichnet durch**
eine erste gesteuerte Schalteinrichtung (110), die die erste Stromquelle (90) oder die zweite Stromquelle (100) mit dem einen Eingang (+) des Komparators (120) verbinden kann, und
eine zweite gesteuerte Schalteinrichtung (60), die die gesteuerte Stromquelle (50) mit dem einen Eingang (+) des Komparators (120) verbinden kann.

7. Schaltungsanordnung nach einem der Ansprüche 1 bis 6, **gekennzeichnet durch**
einen parallel zur Laserdiode (10) geschalteten Widerstand (30).

## Claims

1. Circuit arrangement (5) for switching a laser diode (10) on and off, comprising
at least one laser diode (10) and
a control device, comprising merely one actuator (70, 120), which controls the light power of the laser diode (10) when it is switched on and which controls an initial idle current controlling the laser diode (10) when said laser diode (10) is switched off, in such a way that the initial idle current lies below the characteristic threshold current of the laser diode (10).

2. Circuit arrangement according to claim 1,
**characterised in that**
the control device comprises a photodiode (20) optically coupled to the laser diode (10) and a current source (50) controlled in dependence upon the initial idle current,
wherein the photodiode (20) is only connected to a first current source (90) in the switched-on state and the controlled current source (50) is only connected to a second current source (100) in the switched-off state, whereby the first current source (90) causes a greater initial idle current than the second current source (100).

3. Circuit arrangement according to claim 2,
**characterised in that**
the control device comprises a comparator (120)
and **in that**
the first, second and the controlled current source (90, 100, 50) and also the photodiode (20) can be connected to an input (+) of the comparator (120), and **in that** a reference value can be supplied to the other input (-) of the comparator (120).

4. Circuit arrangement according to claim 2 or 3,
**characterised by**
an ammeter (40) for measuring the initial idle current which is electrically coupled to the controlled current source (50).

5. Circuit arrangement according to claim 3 or 4,
**characterised in that**
an amplifier (70) is arranged after the comparator (120), and **in that**
the ammeter (40) is arranged between the laser diode (10) and the amplifier (70).

6. Circuit arrangement according to one of the claims 3 to 5,
**characterised by**
a first controlled switching device (110) which can connect the first current source (90) or the second current source (100) to one input (+) of the comparator (120), and
a second controlled switching device (60) which can connect the controlled current source (50) to one input (+) of the comparator (120).

7. Circuit arrangement according to one of the claims 1 to 6,
**characterised by**
a resistor (30) connected in parallel with the laser diode (10).

## Revendications

1. Circuit (5) pour mettre sous tension et hors tension une diode laser (10), avec
au moins une diode laser (10), et
un dispositif de réglage qui comporte simplement un élément de réglage (70, 120) et qui, lorsque la diode laser (10) est sous tension, règle la puissance lumineuse et, lorsque la diode laser (10) est hors tension, règle de telle sorte un courant de repos de sortie commandant la diode laser (10) que celui-ci est inférieur au courant de seuil caractéristique de la diode laser (10).

2. Circuit selon la revendication 1,
**caractérisé par le fait que**
le dispositif de réglage comporte une photodiode (20) couplée optiquement à la diode laser (10) et une source de courant (50) commandée en fonction du courant de repos de sortie,
la photodiode (20) étant reliée seulement à l'état sous tension à une première source de courant (90) et la source de courant commandée (50) étant reliée seulement à l'état hors tension à une deuxième source de courant (100), la première source de courant (90) provoquant un plus grand courant de repos de sortie que la deuxième source de courant (100).

3. Circuit selon la revendication 2,
**caractérisé par le fait que**
le dispositif de réglage comporte un comparateur (120), et en ce que
la première, la deuxième et la troisième source de courant (90, 100, 50) ainsi que la photodiode (20) peuvent être connectées à une entrée (+) du comparateur (120), et en ce qu'une grandeur de référence peut être appliquée à l'autre entrée (-) du comparateur (120).

4. Circuit selon la revendication 2 ou 3,
**caractérisé par**
un dispositif de mesure de courant (40), couplé électriquement à la source de courant commandée (50) et qui est destiné à la mesure du courant de repos de sortie.

5. Circuit selon la revendication 3 ou 4,
**caractérisé par le fait que**
un amplificateur (70) est branché en aval du comparateur (120), et en ce que
le dispositif de mesure de courant (40) est disposé entre la diode laser (10) et l'amplificateur (70).

6. Circuit selon l'une des revendications 3 à 5,
**caractérisé par**
un premier commutateur commandé (110) qui peut relier la première source de courant (90) ou la deuxième source de courant (100) à l'entrée (+) du comparateur (120), et
un deuxième commutateur commandé (60) qui peut relier la source de courant commandée (50) à l'entrée (+) du comparateur (120).

7. Circuit selon l'une des revendications 1 à 6,
**caractérisé par**
une résistance (30) branchée en parallèle avec la diode laser (10).
